# EUROPÄISCHE PATENTSCHRIFT

(11) **EP 0 596 061 B1**
(45) Veröffentlichungstag und Bekanntmachung des Hinweises auf die Patenterteilung: **12.08.1998**
(21) Anmeldenummer: 93909360.5
(22) Anmeldetag: 07.05.1993
(51) Int. Cl.: H01L 27/02, H01L 29/08, H02H 9/04

(54) **STROMSPIEGEL MIT WENIGSTENS EINEM PNP-TRANSISTOR**
CURRENT MIRROR WITH AT LEAST ONE PNP TRANSISTOR
MIROIR DE COURANT AVEC AU MOINS UN TRANSISTOR PNP

(30) Priorität: 21.05.1992 DE 4216684
(43) Veröffentlichungstag der Anmeldung: 11.05.1994
(73) Patentinhaber: ROBERT BOSCH GMBH, 70442 Stuttgart (DE)
(72) Erfinder: BROSS, Guenter, D-7427 Hayingen 3 (DE); BYRNE, Gerard, D-7407 Rottenburg-Wurmlingen (DE)
(86) Internationale Anmeldenummer: DE9300401
(87) Internationale Veröffentlichungsnummer: WO9323876

(56) Entgegenhaltungen:
- EP-A- 0 153 492
- DE-A- 3 813 436
- FR-A- 2 466 104
- US-A- 4 730 127

## Beschreibung

### STAND DER TECHNIK

Die Erfindung betrifft einen Stromspiegel mit wenigstens einem pnp-Transistor nach der Gattung des Hauptanspruchs.

Eine derartige Stromquelle ist beispielsweise aus der DE-38 13 436 A1 bekannt. In dieser Druckschrift ist als Ziel angegeben, die Sättigung einer gegebenen lateralen pnp-Transistor-Struktur einer integrierten Schalten typenunabhängig und ohne Einschränkung des Arbeitsbereichs zu verhindern. Hierzu wird ein konzentrisch um den selbstkonzentrischen Kollektor herumgelegter Schutzkollektor benutzt. Ein Schutz gegen Überspannungen ist in dieser Druckschrift nicht offenbart. Darüber hinaus führt der konzentrische Schutzkollektor zu einer großen erforderlichen Transistorfläche, die es zu vermeiden gilt.

In der Druckschrift US 3 987 477 wird ein Stromspiegel mit einem Emitter in einer n-Wanne gezeigt, in der ein Basisanschluß und ein Kollektor vorgesehen sind, die beide gemeinsam an eine Referenzstromquelle angeschlossen sind. Ein weiterer kollektors stellt den Ausgang des Stromspiegels dar.

In der Druckschrift US 3 958 267 wird ein erstes Beispiel für einen Stromspiegel gezeigt. Dabei liegen die einzelnen pnp-Transistoren jeweils in einer separaten n-Wanne, die durch p-Isolationen voneinander getrennt sind. Es wird ein weiterer Stromspiegel gezeigt, bei dem ein Emitter und Kollektoren in einer gemeinsamen n-Wanne angeordnet sind. Die inneren Kollektoren sind mit der Basis zusammengeschaltet und mit einer Referenzstromquelle verbunden. Die äußeren Kollektoren sind mit Ausgangsleitungen des Stromspiegels verbunden. In der Druckschrift wird gelehrt, wie unter dem Schlagwort "current scaling" die Stromverteilung auf mehrere Kollektoren in einer gemeinsamen n-Wanne aufgeteilt wird.

In der Druckschrift US 4 730 127 ist ein Stromspiegel mit einem Referenztransistor und zwei Ausgangstransistoren beschrieben. Die Ausgangstransistoren weisen dabei jeweils drei Teilkollektoren auf, denen entsprechend des gegebenen Layouts Ströme mit dem gewünschten Stromwert entnommen werden können.

Ein Stromspiegel gemäß der Erfindung ist im Hauptanspruch definiert.

### VORTEILE DER ERFINDUNG

Der erfindungsgemäße Stromspiegel mit den kennzeichnenden Merkmalen des Hauptanspruchs hat demgegenüber den Vorteil, daß z.B. der Eingang oder Ausgang des Stromspiegels automatisch ohne Schaltungsaufwand gegen Überspannung geschützt ist, das heißt, es werden weder Komparatoren noch Regelkreise od.dgl. benötigt. Dabei benötigt die Anordnung eine sehr geringe Fläche, wobei der aufgenommene Strom im Überspannungsfall nur bis zu einem Grenzwert ansteigen kann. Dieser Grenzstrom läßt sich durch die Topologie, das heißt durch das Layout, nahezu beliebig reduzieren.

Durch die in den Unteransprüchen aufgeführten Maßnahmen sind vorteilhafte Weiterbildungen und Verbesserungen des im Anspruch 1 angegebenen Stromspiegels möglich.

Durch die Verwendung von zwei pnp-Transistoren in einer Stromspiegelschaltung, die in einer gemeinsamen Wanne mit gemeinsamer Basis nebeneinander angeordnet sind, läßt sich der Effekt dadurch vergrößern, das heißt, der maximale Überstrom wird noch weiter reduziert. Dabei ist zweckmäßigerweise der erste mit der Referenzstromquelle verbundene Teilkollektor des ersten Transistors unmittelbar neben dem zweiten mit dem vor Überspannung zu schützenden Anschluß verbundenen Teilkollektor des zweiten Transistors angeordnet, um dem mit der Referenzstromquelle verbundenen Teilkollektor eine große parasitäre Emitterfläche gegenüberzustellen.

Einen noch besseren Effekt erhält man dadurch, daß die beiden zweiten mit dem Anschluß verbundenen Teilkollektoren der beiden Transistoren einander zugewandt sind, wobei eine weitere, mit der Referenzstromquelle verbundene Kollektorfläche dazwischen angeordnet ist. Diese weitere Kollektorfläche kann streifenförmig oder auch T- oder Doppel-T-förmig ausgebildet sein, um den Emitterstrom der beiden im Überspannungsfall gebildeten parasitären Emitter möglichst optimal aufnehmen zu können.

Eine weitere günstige Anordnung wird dadurch erreicht, daß die beiden ersten mit der Referenzstromquelle verbundenen Teilkollektoren der beiden Transistoren einander zugewandt sind, wobei eine weitere, mit dem Anschluß verbundene Kollektorfläche dazwischen angeordnet ist. Hierbei erweist sich die Ausbildung der weiteren Kollektorfläche als einstückige Kollektorfläche eines weiteren Transistors als besonders günstig. Wenn zusätzlich noch entlang der beiden nach außen weisenden, mit dem Anschluß verbundenen Teilkollektoren der beiden Transistoren weitere mit der Referenzstromquelle verbundene Kollektorflächen angeordnet sind, so kann das Verhältnis des Überspannungsstroms zum Referenzstrom bis auf den Wert 0,75 reduziert werden, so daß ein noch besserer Schutz gegen Überspannungen bzw. Überströme erzeugt werden kann.

Die Innen- und/oder Außenkanten der Kollektoren sind im wesentlichen quadratisch, so daß die Übergangsflächen bzw. Kanten sehr nahe aneinander angeordnet werden können.

### ZEICHNUNG

Ausführungsbeispiele der Erfindung sind in der Zeichnung dargestellt und in der nachfolgenden Beschreibung näher erläutert. Es zeigen:
- Fig. 1: die Topologie von zwei Transistoren in einer Stromspiegelschaltung,
- Fig. 2: das Schaltbild der in Fig. 1 dargestellten Transistoren,
- Fig. 3: ein Strom-Spannungs-Diagramm zur Erläuterung der Wirkungsweise,
- Fig. 4: die Topologie von zwei Transistoren in einer Stromspiegelschaltung mit dazwischen angeordnetem weiteren Kollektor als zweites Ausführungsbeispiel,
- Fig. 5: die Topologie von drei nebeneinander angeordneten Transistoren als zweites Ausführungsbeispiel und
- Fig. 6: das Schaltbild der in Fig. 5 dargestellten Transistoren.

### BESCHREIBUNG DER AUSFÜHRUNGSBEISPIELE

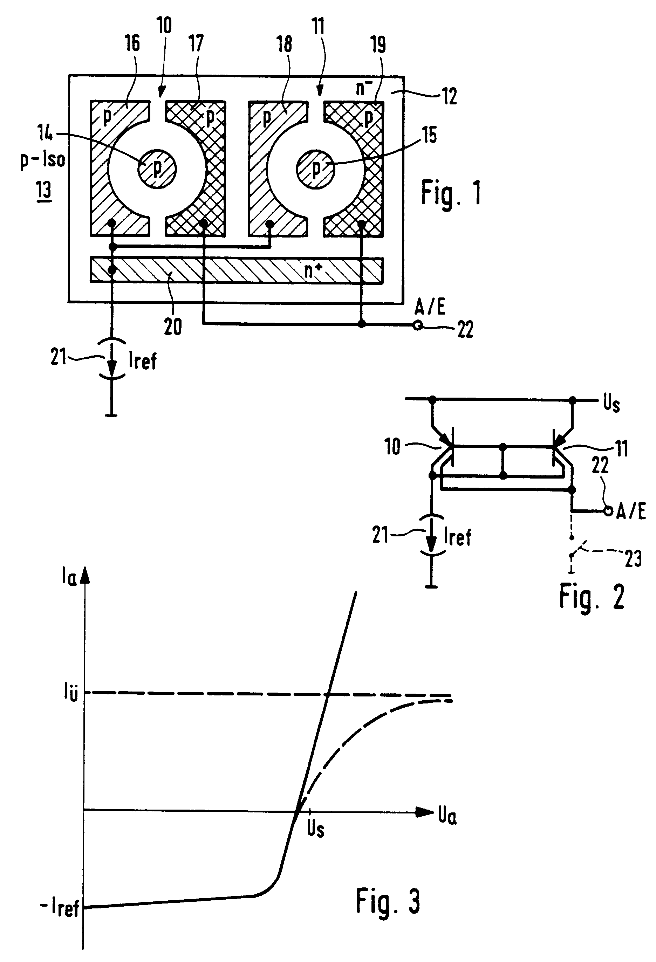

Bei der in Fig. 1 als erstes Ausführungsbeispiel dargestellten Topologie einer lateralen pnp-Transistor-Struktur sind zwei als Stromspiegel geschaltete Transistoren 10,11 nebeneinander in einer n⁻-Wanne 12 angeordnet, die ihrerseits in einer p-Isolation 13 eingebettet ist. Bei jedem der beiden Transistoren 10,11 ist ein kreisscheibenförmiger Emitter 14 bzw. 15 von jeweils zwei Teilkollektoren 16,17 bzw. 18,19 ringförmig umschlossen, wobei die Teilkollektoren 16,17 des Transistors 10 durch eine in der Darstellung vertikale Trennlinie voneinander getrennt sind. Dasselbe trifft für die Teilkollektoren 18,19 des Transistors 11 zu. Während die Innenkontur der Teilkollektoren 16.17 einerseits und 18,19 andererseits im wesentlichen kreisförmig ist, liegt eine im wesentlichen quadratische Außenkontur vor, so daß der in der Darstellung rechte Teilkollektor 17 des Transistors 10 durch einen parallelen Wannenstreifen vom linken Teilkollektor 18 des Transistors 11 getrennt ist. Ein streifenförmiger n⁺-Basisanschluß 20 - im folgenden zur Vereinfachung als "Basis" bezeichnet - verläuft parallel unterhalb der Transistoren 10,11 und erstreckt sich über deren Gesamtlänge. Die beiden linken Teilkollektoren 16,18 der beiden Transistoren 10,11 sind mit der Basis 20 verbunden und gemeinsam an eine Referenzstromquelle 21 angeschlossen. Die beiden jeweils rechten Teilkollektoren 17,19 sind miteinander verbunden und an eine Eingangs-Ausgangs-Klemme (A/E) 22 angechlossen. Anstelle dieser Klemme 12 kann auch z.B. als Anschluß ein interner Schaltungsknoten treten, der gegen Überspannung geschützt werden soll.

Fig. 2 zeigt die in Fig. 1 dargestellte Anordnung als Schaltbild. Die beiden Emitter 14,15 sind mit einer Versorgungsspannung Us beaufschlagt. Die als Stromquelle wirkende dargestellte Anordnung dient beispielsweise zur Erzeugung eines "High"-Potentials an Chip-Ausgängen bzw. -Eingängen mit einer entsprechenden Vorzugslage oder intern in einer Schaltung, in der ein derartiges "High"-Potential erforderlich ist. Ein gestrichelt dargestellter Schalter 23, beispielsweise ein npn-Transistor, kann beispielsweise dazu dienen, das "High"-Potential an der Klemme 22 in ein "Low"-Potential umzuschalten.

Wären die Kollektoren der Transistoren 10,11 als einstückige Kollektoren realisiert, so würde im Überspannungsfall, das heißt bei Anlegen einer die Versorgungsspannung Us übersteigenden Ausgangsspannung Ua an der Klemme 22, der Ausgangsstrom Ia steil ansteigen, was zu einer Zerstörung der Anordnung führen kann. Dies ist durch eine durchgezogene Linie dargestellt.

Aus diesem Grunde ist ein Überspannungsschutz realisiert, der darauf basiert, daß ein pnp-Kollektor als Emitter funktioniert, wenn er auf einem positiveren Potential als der normale Emitter liegt. Wenn daher gemäß Fig. 1 Teilkollektoren eingesetzt werden, können die beiden doppelt-schraffiert dargestellten, mit der Klemme 22 verbundenen Teilkollektoren 17,19 im Überspannungsfall als Emitter gegenüber den anderen Teilkollektoren 16,18 und auch gegenüber dem eigentlichen Emitter 14 bzw. 15 wirken. Der aufgenommene Strom kann nur noch bis zu einem Grenzwert Iü ansteigen, der in einem topologiebedingten Verhältnis zum Spiegel-Referenzstrom Iref steht. Die maximale Überspannung vor der Zerstörung des Bauteils ergibt sich zu Pv/Iü. Pv ist die maximal zulässige Verlustleistung. Iü läßt sich durch das Layout in gewissen Grenzen nahezu beliebig reduzieren. Der immer vorhandene parasitäre Kollektor (p-Isolation 13 und Substrat) erhält durch die Layout-Anordnung nur einen Bruchteil des neuen Emitterstroms der parasitären, durch die Teilkollektoren 17,19 im Überspannungsfall gebildeten Emitter. Der Emitterstrom der parasitären Emitter teilt sich also auf die umliegenden p-Gebiete auf, wie dies bei den gewöhnlichen pnp-Strukturen mit geteilten Kollektoren der Fall ist. So kann beispielsweise der Strom des durch den Teilkollektor 17 im Überspannungsfall gebildeten parasitären Emitter zum linken Emitter 14, zum Teilkollektor 16 und zum Teilkollektor 18 hin abfließen.

Bei einer Anordnung gemäß Fig. 1 kann beispielsweise bei einem Referenzstrom von 220 µA ein Verhältnis von Iü/Iref von 1,5 - 1,7 erreicht werden.

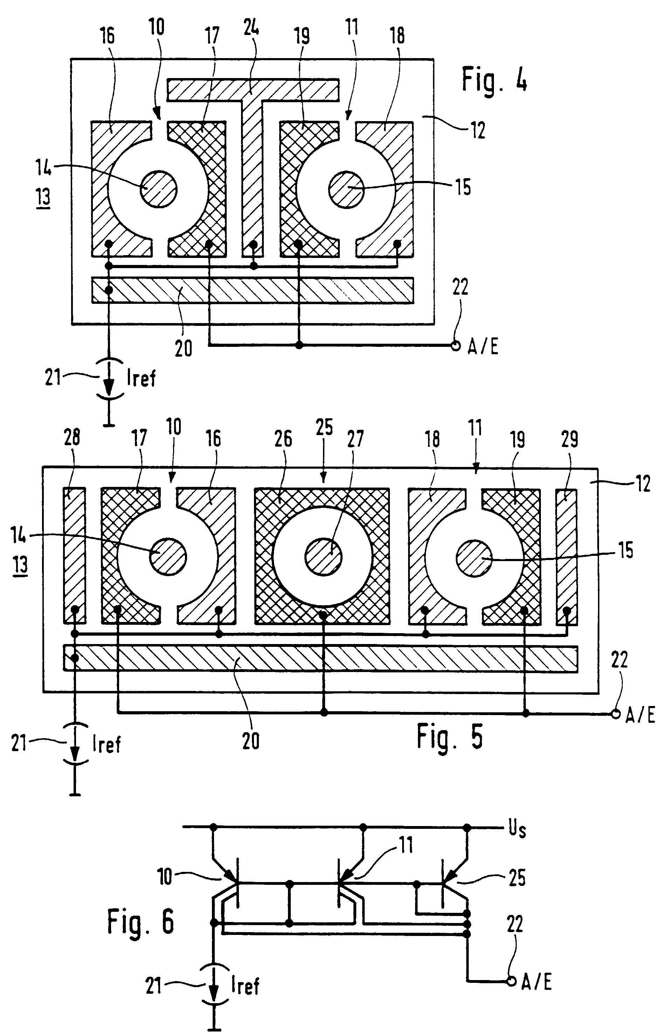

Das in Fig. 4 dargestellte zweite Ausführungsbeispiel entspricht weitgehend dem ersten Ausführungsbeispiel, so daß gleiche oder gleich wirkende Bauteile mit denselben Bezugszeichen versehen und nicht nochmals beschrieben sind.

Der einzige Unterschied besteht darin, daß die Teilkollektoren 18,19 gegenüber dem ersten Ausführungsbeispiel vertauscht sind, so daß nunmehr die beiden mit der Klemme 22 verbundenen Teilkollektoren 17,19 einander zugewandt sind. Dazwischen ist ein T-förmiger weiterer parasitärer Kollektor 24 angeordnet, der mit der Referenzstromquelle 21 verbunden ist. Dabei verläuft der Basisstreifen des T-förmigen Kollektors 24 parallel zwischen den Teilkollektoren 17,19, während der Querast diese Teilkollektoren 17,19 im wesentlichen bis zur Trennstelle zu den Teilkollektoren 16,18 hin überspannt. Anstelle dieses T-förmigen Kollektors 24 kann auch ein einfacherer streifenförmiger Kollektor zwischen den Teilkollektoren 17,19 oder ein Doppel-T-förmiger Kollektor 24 treten, der die Teilkollektoren 17,19 an allen Außenseiten übergreift. Der parasitäre Kollektor kann z.B. absichtlich den Strom im Überspannungsfall begrenzen.

Der zusätzliche Kollektor 24 ist im Normalbetrieb nicht aktiv, er nimmt jedoch im Überspannungsfall einen Teil des Emitterstroms der durch die Teilkollektoren 17,19 gebildeten parasitären Emitter auf, so daß der Isolations- und Substratstromanteil weiter reduziert wird. Durch eine derartige Anordnung läßt sich das Verhältnis von Iü/Iref bis zum Wert 1 reduzieren.

Auch das in Fig. 5 dargestellte dritte Ausführungsbeispiel weist viele Gemeinsamkeiten mit den ersten Ausführungsbeispielen auf, so daß auch hier wiederum gleiche oder gleich wirkende Bauteile mit denselben Bezugszeichen versehen und nicht nochmals beschrieben sind.

Die Topologie der beiden Transistoren 10,11 ist hier so ausgestaltet, daß nunmehr die beiden mit der Klemme 22 verbundenen Teilkollektoren 17,19 voneinander abgewandt. also außen angeordnet sind, während die beiden anderen. mit der Referenzstromquelle 21 verbundenen Teilkollektoren 16,18 einander zugewandt sind. Zwischen diesen Teilkollektoren 16,18 ist ein weiterer Transistor 25 mit einstückigem Kollektor 26 angeordnet, der einen Emitter 27 umgreift. Der Kollektor 26 ist mit der Klemme 22 verbunden, das heißt. er wirkt im Überspannungsfall als zusätzlicher parasitärer Emitter, dessen Strom von den Teilkollektoren 16.18 der Transistoren 10,11 größtenteils aufgenommen wird. Weiterhin sind entlang der Teilkollektoren 17,19 der Transistoren 10,11 weitere streifenförmige Kollektoren 28,29 angeordnet, die parallel zur Außenkante der Teilkollektoren 17,19 verlaufen und mit der Referenzstromquelle 21 verbunden sind.

In Fig. 6 ist das entsprechende Schaltbild der in Fig. 5 dargestellten Topologie-Anordnung dargestellt. Im Überspannungsfalle wirken die mit der Klemme 22 verbundenen Teilkollektoren 17,19 sowie der Kollektor 26 des Transistors 25 als parasitäre Emitter, deren Strom im wesentlichen von den Teilkollektoren 16,18, den zusätzlichen Kollektoren 28,29 und den eigentlichen Emittern 14,15 sowie 27 aufgenommen wird. Durch diese Anordnung kann das Verhältnis Iü/Iref bis auf einen Wert von etwa 0,75 reduziert werden, so daß ein noch besserer Überspannungsschutz erreicht wird.

Selbstverständlich sind noch Variationen der dargestellten und beschriebenen topologischen Flächen möglich. So können die beiden zusätzlichen Kollektoren 28,29 auch L- oder U-förmig ausgebildet sein. Weiterhin können die die Emitter umgreifenden Kollektoren im Einzelfall auch eine runde Einzelkontur haben, wobei benachbarte zusätzliche Kollektoren dann eine entsprechend angepaßte Form aufweisen.

Weiterhin ist die Verwendung von Teilkollektoren oder zusätzlichen Kollektoren zur Rückmeldung für das Auftreten einer Überspannung am Kollektor möglich. wodurch zusätzliche Mittel zur Erfassung solcher Überspannungen entfallen können.

## Patentansprüche

1. Stromspiegel mit wenigstens einem lateralen pnp-Transistor in einer n-Wanne, wobei der pnp-Transistor eine Basis (20), einen Emitter (14), einen ersten (16) und einen zweiten Teilkollektor (17) aufweist, wobei der Emitter (14) mit dem positiven Pol einer Spannungsquelle verbunden ist, an dem eine erste positive Spannung (U_{S}) anliegt,
wobei eine Referenzstromquelle (21) vorgesehen ist, die mit der Basis (20) und dem ersten Teilkollektor (16) elektrisch verbunden ist,
wobei der zweite Teilkollektor (17) mit einem vor Überspannung zu schützenden Anschluß (22) verbunden ist,
wobei erster und zweiter Teilkollektor gemeinsam den Emitter im wesentlichen ringförmig umgreifen,
dadurch gekennzeichnet, daß ein dritter Teilkollektor (18; 18, 24; 18, 28) vorgesehen ist, der mit der Referenzstromquelle (21) verbunden ist
und daß der zweite Teilkollektor (17) zwischen dem ersten und dem dritten Teilkollektor angeordnet ist
und daß im Falle einer am Anschluß (22) anliegenden zweiten positiven Spannung, die größer ist als die am positiven Pol der Spannungsquelle anliegende erste positive Spannung (U_{S}) die Funktion des Emitters vom zweiten Teilkollektor (17) übernehmbar ist.

2. Stromspiegel nach Anspruch 1, dadurch gekennzeichnet, daß ein vierter Teilkollektor (19) vorgesehen ist, der mit dem Anschluß (22) verbunden ist, wobei der dritte Teilkollektor (18) zwischen dem zweiten und dem vierten Teilkollektor (17, 19) angeordnet ist, wobei ein erster pnp-Teiltransistor (10) zusammen mit Basis (20) und Emitter (14) durch den ersten und zweiten Teilkollektor (16, 17) und ein zweiter pnp-Teiltransistor (11) zusammen mit Basis (20) und einem Teilemitter (15) durch den dritten und vierten Teilkollektor (18, 19) gebildet sind.

3. Stromspiegel nach Anspruch 1, dadurch gekennzeichnet, daß ein vierter Teilkollektor (19) vorgesehen ist, der mit dem Anschluß (22) verbunden ist, daß der dritte Teilkollektor (18, 24) eine separate Kollektorfläche (24) aufweist, die zwischen dem zweiten und dem vierten Teilkollektor (17, 19) angeordnet ist, und daß durch den vierten Teilkollektor (19), den dritten Teilkollektor (18, 24) und einen Teilemitter (15) zusammen mit der Basis (20) ein zweiter pnp-Teiltransistor (11) gebildet ist.

4. Stromspiegel nach Anspruch 1, dadurch gekennzeichnet, daß ein vierter Teilkollektor (19) vorgesehen ist, der mit dem Anschluß (22) verbunden ist, daß eine weitere Kollektorfläche (26) vorgesehen ist, die mit dem Anschluß (22) verbunden ist und zwischen dem ersten Teilkollektor (16) und dem dritten Teilkollektor (18) angeordnet ist, und daß durch den vierten Teilkollektor (19), den dritten Teilkollektor (18) und einen Teilemitter (15) zusammen mit der Basis (20) ein zweiter pnp-Teiltransistor (11) gebildet ist.

5. Stromspiegel nach Anspruch 3, dadurch gekennzeichnet, daß wenigstens ein streifenförmiger Bereich der Kollektorfläche (24) entlang der einander zugewandten Randbereiche des zweiten (17) und vierten (19) Teilkollektors verläuft.

6. Stromspiegel nach Anspruch 5, dadurch gekennzeichnet, daß die Kollektorfläche (24) I-, T- oder doppel-T-förmig ausgebildet ist.

7. Stromspiegel nach Anspruch 4, dadurch gekennzeichnet, daß die weitere Kollektorfläche (26) die einstückige Kollektorfläche eines zusammen mit einem weiteren Teilemitter (27) gebildeten weiteren Teiltransistors (25) ist.

8. Stromspiegel nach Anspruch 4 oder 7, dadurch gekennzeichnet, daß entlang der beiden nach außen weisenden, mit dem Anschluß (22) verbundenen Teilkollektoren (17, 19), Kollektorflächen (28, 29) angeordnet sind, die mit der Referenzstromquelle (21) verbunden sind.

9. Stromspiegel nach einem der vorhergehenden Ansprüche, dadurch gekennzeichnet, daß die vom jeweils zuordenbaren Teilemitter bezichungsweise Emitter abgewandten Kanten der Teilkollektoren im wesentlichen quadratisch ausgebildet sind.

10. Stromspiegel nach einem der vorhergehenden Ansprüche, dadurch gekennzeichnet, daß der Anschluß (22) der beschaltbare Ein- oder Ausgang des Stromspiegels ist.

## Claims

1. Current mirror with at least one lateral pnp transistor in an n-type well, the pnp transistor having a base (20), an emitter (14), a first collector element (16) and a second collector element (17), the emitter (14) being connected to the positive pole of a voltage source, at which a first positive voltage (Uₛ) is present,
a reference current source (21) being provided, which is electrically connected to the base (20) and the first collector element (16),
the second collector element (17) being connected to a terminal (22) which is to be protected against overvoltage,
the first and second collector elements jointly encompassing the emitter in an essentially annular manner,
characterized in that a third collector element (18; 18, 24; 18, 28) is provided, which is connected to the reference current source (21),
and in that the second collector element (17) is arranged between the first and third collector elements,
and in that in the event of a second positive voltage being present at the terminal (22) which is greater than the first positive voltage (Uₛ) present at the positive pole of the voltage source, the function of the emitter can be taken over by the second collector element (17).

2. Current mirror according to Claim 1, characterized in that a fourth collector element (19) is provided, which is connected to the terminal (22), the third collector element (18) being arranged between the second and the fourth collector element (17, 19), a first pnp transistor element (10) being formed by the first and second collector elements (16, 17) together with the base (20) and emitter (14), and a second pnp transistor element (11) being formed by the third and fourth collector elements (18, 19) together with the base (20) and an emitter element (15).

3. Current mirror according to Claim 1, characterized in that a fourth collector element (19) is provided, which is connected to the terminal (22), in that the third collector element (18, 24) has a separate collector area (24), which is arranged between the second and the fourth collector element (17, 19), and in that a second pnp transistor element (11) is formed by the fourth collector element (19), the third collector element (18, 24) and an emitter element (15) together with the base (20).

4. Current mirror according to Claim 1, characterized in that a fourth collector element (19) is provided, which is connected to the terminal (22), in that a further collector area (26) is provided, which is connected to the terminal (22) and is arranged between the first collector element (16) and the third collector element (18), and in that a second pnp transistor element (11) is formed by the fourth collector element (19), the third collector element (18) and an emitter element (15) together with the base (20).

5. Current mirror according to Claim 3, characterized in that at least one strip-shaped region of the collector area (24) runs along the mutually facing edge regions of the second collector element (17) and fourth collector element (19).

6. Current mirror according to Claim 5, characterized in that the collector area (24) is designed in the shape of an I, T or double T.

7. Current mirror according to Claim 4, characterized in that the further collector area (26) is the one-piece collector area of a further transistor element (25) which is formed together with a further emitter element (27).

8. Current mirror according to Claim 4 or 7, characterized in that collector areas (28, 29) which are connected to the reference current source (21) are arranged along the two outwardly facing collector elements (17, 19) connected to the terminal (22).

9. Current mirror according to one of the preceding claims, characterized in that those edges of the collector elements which face away from the respectively assignable emitter element or emitter are designed such that they are essentially square.

10. Current mirror according to one of the preceding claims, characterized in that the terminal (22) is the connectable input or output of the current mirror.

## Revendications

1. Miroir de courant comprenant au moins un transistor (pnp) latéral dans une cuvette (n),
le transistor (pnp) ayant une base (20), un émetteur (14), un premier et un second collecteur partiel (16, 17), l'émetteur (14) étant relié au pôle positif d'une source de tension à laquelle est appliquée une première tension positive (Uₛ),
une source de courant de référence (21) reliée électriquement à la base (20) et au premier collecteur partiel (16), le second collecteur partiel (17) étant relié à un branchement (22) à protéger contre la surtension,
un premier et un second collecteur partiel entourent en commun l'émetteur d'une manière essentiellement annulaire,
caractérisé par
un troisième collecteur partiel (18 ; 18, 24 ; 18, 28) relié à la source de courant de référence (21),
le second collecteur partiel (17) étant prévu entre le premier et le troisième collecteur partiel,
et en cas d'une seconde tension positive appliquée au branchement (22), qui serait supérieure à la première tension positive (Uₛ) appliquée au pôle positif de la source de tension, le rôle de l'émetteur est assuré par le second collecteur partiel (17).

2. Miroir de courant selon la revendication 1,
caractérisé par
un quatrième collecteur partiel (19) relié au branchement (22),
le troisième collecteur partiel (18) étant prévu entre le second et le quatrième collecteur partiel (17, 19), un premier transistor partiel (pnp), (10) en même temps qu'une base (20) et l'émetteur (14) étant formés par le premier et le second collecteur partiels (16, 17) et un second transistor partiel (pnp) (11) avec la base (20) et un émetteur partiel (15) étant formés par le troisième et le quatrième collecteur partiel (18, 19).

3. Miroir de courant selon la revendication 1,
caractérisé par
un quatrième collecteur partiel (19) relié au branchement (22),
le troisième collecteur partiel (18, 24) ayant une surface de collecteur (24) séparée, entre le second et le quatrième collecteur partiel (17, 19) et
le quatrième collecteur partiel (19), le troisième collecteur partiel (18, 24) et un émetteur partiel (15) formant avec la base (20), un second transistor partiel (pnp) (11).

4. Miroir de courant selon la revendication 1,
caractérisé par
un quatrième collecteur partiel (19) relié au branchement (22),
une autre surface de collecteur (26) reliée au branchement (22) est prévue entre le premier (16) et le troisième collecteur partiel (18), et
le quatrième collecteur partiel (19), le troisième collecteur partiel (18), un collecteur partiel (15) et la base (20), forment un second transistor partiel (pnp) (11).

5. Miroir de courant selon la revendication 3,
caractérisé en ce qu'
au moins une zone en forme de bande de la surface de collecteur (24) passe le long des zones de bord tournées l'une vers l'autre du second (17) et quatrième (19) collecteur partiels.

6. Miroir de courant selon la revendication 5,
caractérisé en ce que
les surfaces de collecteur (24) sont en forme de (I), de (T) ou de double (T).

7. Miroir de courant selon la revendication 4,
caractérisé en ce que
l'autre surface de collecteur (26) est la surface de collecteur unique d'un autre transistor partiel (25) relié à un autre émetteur partiel (27).

8. Miroir de courant selon la revendication 4 ou 7,
caractérisé en ce que
des surfaces de collecteur (28, 29) reliées à la source de courant de référence (21) sont prévues le long des deux collecteurs partiels (17, 19) reliés au branchement (22) et tournés vers l'extérieur.

9. Miroir de courant selon l'une des revendications précédentes,
caractérisé en ce que
les bords des collecteurs partiels opposés à l'émetteur partiel, ou à l'émetteur respectivement associé sont de forme essentiellement rectangulaire.

10. Miroir de courant selon l'une des revendications précédentes,
caractérisé en ce que
le branchement (22) est l'entrée ou la sortie commutable du miroir de courant.
